# EUROPÄISCHE PATENTANMELDUNG

(11) **EP 3 570 052 A1**
(43) Veröffentlichungstag der Anmeldung: **20.11.2019**
(21) Anmeldenummer: 18173201.7
(22) Anmeldetag: 18.05.2018
(51) Int. Cl.: G01R 31/12, G01R 31/34

(54) **VERFAHREN ZUR MESSUNG EINES GEPULSTEN HOCHFREQUENTEN EREIGNISSIGNALS**

(71) Anmelder: Siemens Aktiengesellschaft, 80333 München (DE)
(72) Erfinder: Bormann, Ulf, 90518 Altdorf (DE); Kröppel, Sebastian, 96114 Hirschaid (DE); Scheibner, Dirk, 90473 Nürnberg (DE); Schimmer, Jürgen, 90473 Nürnberg (DE); Wiegand, Hermann-Josef, 36169 Rasdorf (DE); Meyer, Martin, 90425 Nürnberg (DE)

(57) **Zusammenfassung**

Die Erfindung betrifft ein Verfahren zur Messung eines gepulsten hochfrequenten Ereignissignals (HF), insbesondere einer Teilentladung, in einer elektrischen rotierenden Maschine (2). Um im Vergleich zum Stand der Technik, eine einfache und kostengünstige Implementierung zu erreichen, wird vorgeschlagen, dass das Ereignissignal (HF) aus einem hochfrequenten elektromagnetischen Feld mit Hilfe eines Sensors (30) während eines Betriebes der elektrischen rotierenden Maschine (2) ausgekoppelt wird, wobei aus dem ausgekoppelten Ereignissignal (HF) mit Hilfe einer Hochfrequenz-Detektorschaltung (34) ein pulsförmiges niederfrequentes Hüllkurvensignal (HK) ermittelt wird, wobei, wenn eine Amplitude des Hüllkurvensignals (HK) einen Schwellwert (Sw) überschreitet, ein Ereignissignal (HF) erfasst wird.

## Beschreibung

Die Erfindung betrifft ein Verfahren zur Messung eines gepulsten hochfrequenten Ereignissignals, insbesondere einer Teilentladung, in einer elektrischen rotierenden Maschine.

Des Weiteren betrifft die Erfindung eine Steuereinheit mit Mitteln zur Durchführung eines derartigen Verfahrens.

Darüber hinaus betrifft die Erfindung ein Computerprogramm zur Durchführung eines derartigen Verfahrens bei Ablauf in einer Steuereinheit.

Überdies betrifft die Erfindung ein Computerprogrammprodukt mit einem Computerprogramm.

Ferner betrifft die Erfindung eine Sensorvorrichtung zur Durchführung eines derartigen Verfahrens.

Zudem betrifft die Erfindung eine elektrische rotierende Maschine mit mindestens einer Sensorvorrichtung.

Ein derartiges Verfahren wird in elektrischen rotierenden Hochspannungsmaschinen, insbesondere Hochspannungsmotoren und Hochspannungsgeneratoren, verwendet, welche mit einer Spannung von mindestens 1kV betreibbar sind.

Unter gepulsten hochfrequenten Ereignissignalen sind beispielsweise Ereignissignale zu verstehen, die einen pulsförmigen Basisbandanteil aufweisen, welcher auf einem hochfrequenten Trägersignal aufmoduliert ist. Das hochfrequente Trägersignal weist eine Frequenz zumindest im Bereich von mindestens 100kHz. Derartige gepulste hochfrequente Ereignissignale entstehen beispielsweise bei Teilentladungen, die bei elektrischen rotierenden Hochspannungsmaschinen häufig auftreten. Bei Teilentladungen handelt es sich um lokale Entladungen, welche beispielsweise durch Inhomogenitäten in einem Isolierstoff verursacht werden und unter Umständen langfristig zum Versagen der Isolierung und damit zu einem Ausfall der Hochspannungsmaschine führen. Deshalb werden elektrische rotierende Hochspannungsmaschinen regelmäßig auf Teilentladung untersucht. Insbesondere bei einer deutlichen Veränderung der Häufigkeit von Teilentladung ist es erforderlich, die Ursache zu finden.

Die Teilentladungspulse weisen meist eine sehr kurze Dauer von unter 1µs auf und sind auf einem hochfrequenten Trägersignal mit einer Frequenz im MHz-Bereich aufmoduliert. Beispielsweise werden Teilentladungen an Versorgungsleitungen der elektrischen rotierenden Maschine gemessen. Für die Erfassung von Teilentladungen gibt es eine Vielzahl von teilweise, beispielsweise nach DIN EN 60270, genormten Messverfahren. Fast ausschließlich werden Offline-Messungen durchgeführt, bei denen der eigentliche Betrieb der elektrischen rotierenden Maschine unterbrochen wird.

Die Patentschrift EP 0 662 220 B1 beschreibt eine Auskopplung eines hochfrequenten Ereignissignals aus einem hochfrequenten elektromagnetischen Feld in einer elektrischen Großmaschine mit einem eine elektrische Wicklung tragenden und mit zumindest einem Temperaturfühler bestückten Ständer. Erfindungsgemäß ist das hochfrequente Ereignissignal von dem als Antenne benutzten Temperaturfühler abzunehmen. Auf diese Weise wird der apparative Aufwand zur Auskopplung des Ereignissignals gering gehalten, und bei Verwendung einer Vielzahl von Temperaturfühlern ist eine Ortung eines Schadens, wo das Ereignissignal verursacht wurde, möglich.

Die Patentschrift DE 10 2011 006 098 B4 beschreibt eine Einrichtung zur Feststellung von Teilentladungen in einem Isolationssystem von rotierenden elektrischen Maschinen mit einem Koppler mit kapazitiver Auskopplung mittels eines Koppelkondensators mit einer Kapazität kleiner 500pF als Hochpass und einer mit dem Koppler verbundenen oder verbindbaren Adaptereinrichtung für den Koppler mit einer Frequenzweiche zur Aufteilung des ausgekoppelten Signals in ein Hochfrequenzsignal und ein Niederfrequenzsignal und einem Mischer für das Hochfrequenzsignal und das Niederfrequenzsignal zum Umsetzen des Hochfrequenzsignals, so dass wenigstens das umgesetzte Hochfrequenzsignal an der Adaptereinrichtung abgreifbar und über eine mit der Adaptereinrichtung verbindbare Auswerteeinrichtung auswertbar ist.

Der Erfindung liegt die Aufgabe zugrunde, ein Verfahren zur Messung eines gepulsten hochfrequenten Ereignissignals, insbesondere einer Teilentladung, in einer elektrischen rotierenden Maschine anzugeben, welches, im Vergleich zum Stand der Technik, einfach und kostengünstig zu implementieren ist.

Die Aufgabe wird erfindungsgemäß durch ein Verfahren zur Messung eines gepulsten hochfrequenten Ereignissignals, insbesondere einer Teilentladung, in einer elektrischen rotierenden Maschine gelöst, wobei das Ereignissignal aus einem hochfrequenten elektromagnetischen Feld mit Hilfe eines Sensors während eines Betriebes der elektrischen rotierenden Maschine ausgekoppelt wird, wobei aus dem ausgekoppelten Ereignissignal mit Hilfe einer Hochfrequenz-Detektorschaltung ein pulsförmiges niederfrequentes Hüllkurvensignal ermittelt wird, wobei, wenn eine Amplitude des Hüllkurvensignals einen Schwellwert überschreitet, ein Ereignissignal erfasst wird.

Ferner wird die Aufgabe erfindungsgemäß durch eine Steuereinheit mit Mitteln zur Durchführung eines derartigen Verfahrens gelöst.

Darüber hinaus wird die Aufgabe erfindungsgemäß durch ein Computerprogramm zur Durchführung eines derartigen Verfahrens bei Ablauf in einer Steuereinheit gelöst.

Zudem wird die Aufgabe erfindungsgemäß durch ein Computerprogrammprodukt mit einem Computerprogramm gelöst.

Des Weiteren wird die Aufgabe erfindungsgemäß durch eine Sensorvorrichtung zur Durchführung eines derartigen Verfahrens gelöst, welche zumindest einen Sensor und eine Steuereinheit aufweist.

Überdies wird die Aufgabe erfindungsgemäß durch eine elektrische rotierende Maschine mit mindestens einer Sensorvorrichtung gelöst.

Die in Bezug auf das Verfahren nachstehend angeführten Vorteile und bevorzugten Ausgestaltungen lassen sich sinngemäß auf die Steuereinheit, das Computerprogramm, das Computerprogrammprodukt, die Sensorvorrichtung und die elektrische rotierende Maschine übertragen.

Der Erfindung liegt die Überlegung zugrunde, gepulste hochfrequente Ereignissignale während des Betriebes einer elektrischen rotierenden Maschine möglichst einfach und kostengünstig zu erfassen. Zur elektrischen rotierenden Maschine gehören auch mit der Maschine verbundene Komponenten wie Kabel, Transformatoren, Filter, usw., in welchen derartige Ereignissignale erfassbar sind. Gepulste hochfrequente Ereignissignale sind beispielsweise Teilentladungen, welche einen Puls, beispielsweise mit einer Pulsdauer von mindestens 200ns, umfassen, der auf einen hochfrequenten Träger, beispielsweise mit einer Frequenz von mindestens 20MHz, aufmoduliert ist. Eine direkte Digitalisierung des gepulsten hochfrequenten Ereignissignals würde einen schnellen und teuren Analog-Digital-Umsetzer sowie schnelle und teure Digitalschaltungen erfordern, welche eine hohe Leistungsaufnahme aufweisen. Daher wird das gepulste hochfrequente Ereignissignal mit Hilfe einer Hochfrequenz-Detektorschaltung weiterverarbeitet, wobei mit Hilfe der Hochfrequenz-Detektorschaltung ein pulsförmiges niederfrequentes Hüllkurvensignal extrahiert wird. Die Hochfrequenz-Detektorschaltung ist beispielsweise bis zu einer Frequenz von 1GHz verwendbar. Das Hüllkurvensignal des Ereignissignals wird, beispielsweise mit Hilfe eines Schwellenwertschalters, mit einem Schwellwert verglichen, wobei, sobald der Schwellwert überschritten wird, ein Ereignissignal erfasst wird. Ein Schwellenwertschalter ist beispielsweise ein Komparator oder ein Schmitt-Trigger.

Die gepulsten hochfrequenten Ereignissignale werden von einer Sensorvorrichtung erfasst, welche zumindest einen Sensor aufweist. Der Sensor ist beispielsweise als kapazitive oder induktive Kopplungsvorrichtung, als Richtkoppler oder als ein anderer Sensor ausgestaltet. Durch eine Steuereinheit wird der Verfahrensablauf gesteuert.

Die Mittel zur Durchführung des Verfahrens umfassen ein Computerprogramm und beispielweise einen Mikrocontroller oder einen anderen programmierbaren Logikbaustein. Die Steuereinheit ist beispielsweise dem Mikrocontroller zugeordnet.

In einer bevorzugten Ausführungsform ist die Hochfrequenz-Detektorschaltung derartig konfiguriert, dass die Amplitude des Hüllkurvensignals im Wesentlichen proportional proportional zum Logarithmus der Amplitude des Ereignissignals ist. Die logarithmische Kennlinie der Detektorschaltung ist vorteilhaft, weil Signalanteilen des Hüllkurvensignals mit niedrigerer Amplitude ein größerer Dynamikbereich zugewiesen wird während Signalanteile des Hüllkurvensignals mit höherer Amplitude in ihrer Dynamik beschränkt werden. Ferner ist ein Hüllkurvensignal mit einem durch eine logarithmische Kennlinie beschränkten Amplitudenbereich einfach weiterzuverarbeiten.

Bei einer bevorzugten Ausgestaltung wird ein Temperaturfühler, welcher eine Antenne umfasst, als Sensor zum Auskoppeln des Ereignissignals verwendet. Beispielsweise werden Zuleitungen des Temperaturfühlers als Antenne zum Auskoppeln des Ereignissignals aus dem hochfrequenten elektromagnetischen Feld verwendet. Ein derartiger Temperaturfühler ist bereits in der elektrischen rotierenden Maschine vorhanden. Da sich die niederfrequente Messung der Temperatur sowie die Erfassung der gepulsten hochfrequenten Ereignissignale aufgrund der unterschiedlichen Frequenzbereiche nicht merklich beeinflussen, ist ein derartiger Temperaturfühler als Sensor einfach, kostengünstig und platzsparend.

Besonders vorteilhaft wird das gepulste hochfrequente Ereignissignal nach dem Auskoppeln durch den Sensor von einem niederfrequenten Sensorsignal, insbesondere mit Hilfe einer Frequenzweiche, getrennt. Eine Frequenzweiche ist eine, insbesondere passive, elektrische Schaltung, welche so ausgeführt ist, dass diese bezüglich eines ersten Ausgangs als Tiefpassfilter und bezüglich eines zweiten Ausgangs als Hochpassfilter wirkt. Durch eine derartige Frequenzweiche ist es leicht und verlustarm möglich, beispielsweise ein niederfrequentes Temperatursignal von einem gepulsten hochfrequenten Ereignissignal zu trennen und separat weiterzuverarbeiten.

Bei einer weiteren vorteilhaften Ausführungsform werden eine Anzahl von Ereignissignalen und/oder eine Zeitdauer zumindest eines Ereignissignals ermittelt. Sowohl die Anzahl der Ereignissignale als auch die Zeitdauer zumindest eines Ereignissignals sind leicht und mit wenigen, insbesondere analogen, Schaltungskomponenten ermittelbar.

Bei einer weiteren vorteilhaften Ausgestaltung wird ein Maximalwert der Amplitude zumindest eines Teils des Hüllkurvensignals mit Hilfe eines ersten Spitzenwertdetektors ermittelt. Ein Spitzenwertdetektor ist eine analoge Schaltung, welche einen Spitzenwert eines Eingangssignals ausgangsseitig ausgibt. Durch den ersten Spitzenwertdetektor, insbesondere zusammen mit dem Hochfrequenz-Detektor, ist der Maximalwert des Hüllkurvensignals leicht und energiesparend ermittelbar. Ferner ermöglicht der Spitzenwertdetektor den Einsatz einer kostengünstigeren digitalen Signalverarbeitung.

Besonders vorteilhaft werden der erste Spitzenwertdetektor und ein gleichartiger zweiter Spitzenwertdetektor im Wechsel, insbesondere bei einer fallenden Flanke des Hüllkurvensignals, aktiviert und deaktiviert. Durch eine derartige alternierende analoge Signalverarbeitung wird die nachfolgende digitale Signalverarbeitung zusätzlich entlastet, was dazu führt, dass noch günstigere digitale Komponenten mit einer niedrigeren Leistungsaufnahme verwendbar sind.

Bei einer weiteren vorteilhaften Ausführungsform wird eine Leistung zumindest eines Teils des Hüllkurvensignals mit Hilfe eines ersten Integrators ermittelt. Ein Integrator ist eine analoge Schaltung, welche über einen vorgegebenen Zeitraum ein Eingangssignal integriert und das Integral ausgangsseitig ausgibt. Durch den analogen ersten Integrator, insbesondere zusammen mit dem Hochfrequenz-Detektor, ist eine Leistung des Hüllkurvensignals leicht und energiesparend ermittelbar. Ferner ermöglicht der Spitzenwertdetektor den Einsatz einer kostengünstigeren digitalen Signalverarbeitung.

Besonders vorteilhaft werden der erste Integrator und ein gleichartiger zweiter Integrator im Wechsel, insbesondere bei einer fallenden Flanke des Hüllkurvensignals, aktiviert und deaktiviert. Durch eine derartige alternierende analoge Signalverarbeitung wird die nachfolgende digitale Signalverarbeitung zusätzlich entlastet, was dazu führt, dass noch günstigere digitale Komponenten mit einer niedrigeren Leistungsaufnahme verwendbar sind.

In einer bevorzugten Ausgestaltung werden eine Anzahl von Ereignissignalen, eine Zeitdauer zumindest eines Ereignissignals, ein Maximalwert der Amplitude zumindest eines Teils des Hüllkurvensignals und/oder eine Leistung zumindest eines Teils des Hüllkurvensignals digitalisiert. Eine Digitalisierung erfolgt beispielsweise mit einem Analog-Digital-Umsetzer und ermöglicht eine rechnerbasierte Weiterverarbeitung der Informationen in einem übergeordneten System, beispielsweise in einer Cloud.

Bei einer weiteren vorteilhaften Ausgestaltung werden die digitalisierten Daten zumindest teilweise in einer zentralen IT-Infrastruktur weiter verarbeitet. Eine zentrale IT-Infrastruktur ist beispielsweise mindestens ein lokales Computersystem und/oder eine Cloud. Die IT-Infrastruktur stellt Speicherplatz, Rechenleistung und/oder Anwendungssoftware bereit. In der Cloud werden Speicherplatz, Rechenleistung und/oder Anwendungssoftware als Dienstleistung über das Internet zur Verfügung gestellt. Durch eine Verlagerung zumindest eines Teils der digitalen Signalverarbeitung in eine zentrale IT-Infrastruktur wird die Leistungsaufnahme der Komponenten im Bereich der elektrischen rotierenden Maschine verringert. Die Bereitstellung der digitalisierten Daten in der zentralen IT-Infrastruktur ermöglicht eine Bereitstellung von Services über eine IoT-Plattform, welche beispielsweise auf einer Cloud aufsetzt.

Im Folgenden wird die Erfindung anhand der in den Figuren dargestellten Ausführungsbeispiele näher beschrieben und erläutert.

Es zeigen:
- FIG 1: einen Längsschnitt einer elektrischen rotierenden Maschine mit einer Sensorvorrichtung und
- FIG 2: ein Blockschaltbild einer ersten Ausführungsform ei-ner Sensorvorrichtung,
- FIG 3: ein Blockschaltbild einer zweiten Ausführungsform einer Sensorvorrichtung und
- FIG 4: ein Blockschaltbild einer dritten Ausführungsform einer Sensorvorrichtung.

Bei den im Folgenden erläuterten Ausführungsbeispielen handelt es sich um bevorzugte Ausführungsformen der Erfindung. Bei den Ausführungsbeispielen stellen die beschriebenen Komponenten der einzelnen Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

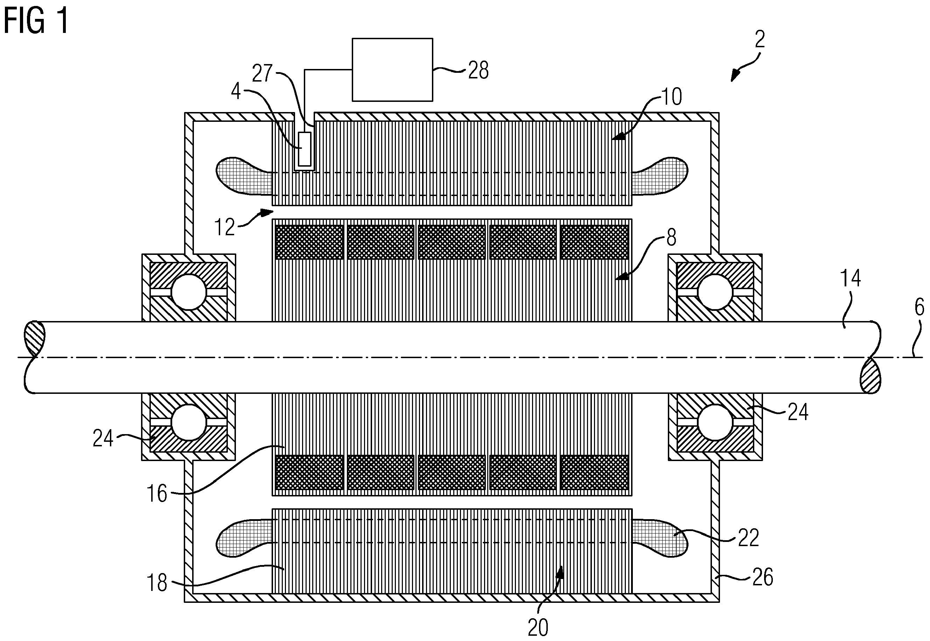

FIG 1 zeigt einen Längsschnitt einer elektrischen rotierenden Maschine 2 mit einer Sensorvorrichtung 4. Die elektrische rotierende Maschine 2 ist exemplarisch als permanenterregte Synchronmaschine ausgeführt, wobei weitere Maschinentypen, wie beispielsweise Asynchronmaschinen, ebenfalls zum Gegenstand der Erfindung gehören.

Die elektrische rotierende Maschine 2 weist einen um eine Rotationsachse 6 rotierbaren Rotor 8 und einen den Rotor 8 umgebenden Stator 10 auf, wobei sich zwischen dem Rotor 8 und dem Stator 10 ein Spalt 12, der insbesondere als Luftspalt ausgeführt ist, befindet. Die Rotationsachse 6 definiert eine Axialrichtung und eine Radialrichtung. Der Rotor 8 umfasst eine Welle 14 und ein Rotorblechpaket 16. Der Stator 10 umfasst ein Statorblechpaket 18 mit Statorwicklungen 20, wobei das Statorblechpaket 18 aus einer Vielzahl von geschichteten Elektroblechen aufgebaut ist. Die Statorwicklungen 20 verlaufen in Axialrichtung durch das Statorblechpaket 18 und bilden an den axialen Enden des Statorblechpakets 18 Wickelköpfe 22 aus. Die Welle 14 des Rotors 8 ist über Lager 24 gelagert. Der Rotor 8 und der Stator 10 sind in einem geschlossenen Maschinengehäuse 26 untergebracht.

Die Sensorvorrichtung 4 ist, beispielsweise in einem Kanal 27, welcher durch das Statorblechpaket 18 verläuft, im Bereich der Statorwicklungen 20 angeordnet. Die Anordnung der Sensorvorrichtung 4 ist nur schematisch, wobei der Kanal 27 auch anders ausgeführt sein kann. Beispielsweise ist der Kanal 27 in eine andere Richtung, beispielsweise um 90° gedreht, durch das Blechpaket verlaufend angeordnet. Darüber hinaus ist die Sensorvorrichtung 4 mit einer IT-Infrastruktur 28 verbunden. Eine IT-Infrastruktur 28 ist beispielsweise mindestens ein lokales Computersystem und/oder eine Cloud. Die IT-Infrastruktur 28 stellt Speicherplatz, Rechenleistung und/oder Anwendungssoftware bereit. In der Cloud werden Speicherplatz, Rechenleistung und/oder Anwendungssoftware als Dienstleistung über das Internet zur Verfügung gestellt. Die digitale Datenübertragung an die IT-Infrastruktur 28 findet drahtlos, drahtgebunden oder optisch statt. Beispielsweise werden die Daten über Bluetooth oder WLAN übertragen.

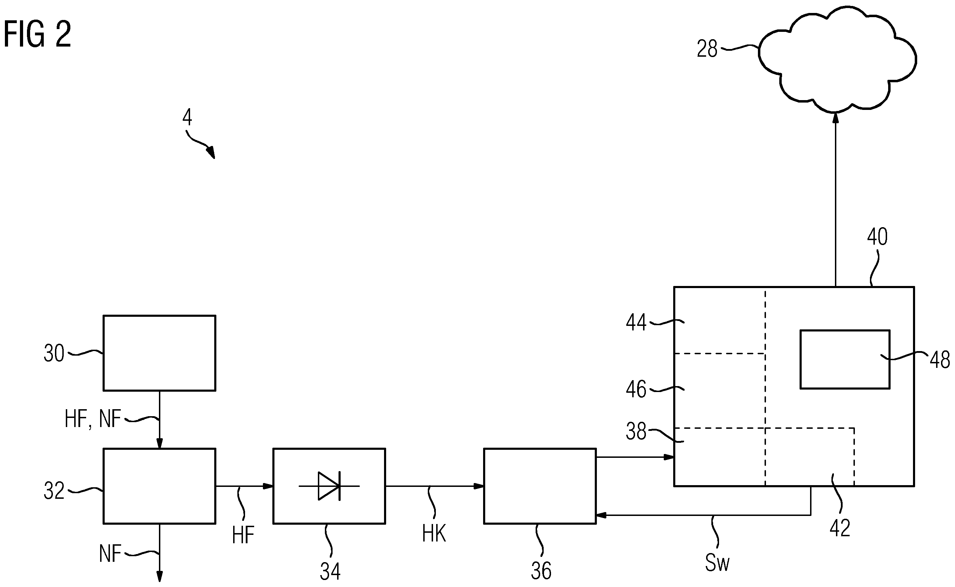

FIG 2 zeigt ein Blockschaltbild einer ersten Ausführungsform einer Sensorvorrichtung 4, welche mit der IT-Infrastruktur 28 verbunden ist. Die Sensorvorrichtung 4 umfasst einen Sensor 30, welcher Mittel zum Auskoppeln eines gepulsten hochfrequenten Ereignissignals HF aus einem hochfrequenten elektromagnetischen Feld während eines Betriebes der elektrischen rotierenden Maschine 2 aufweist. Unter einem gepulsten hochfrequenten Signal ist beispielsweise ein Puls mit einer Pulsdauer von mindestens 200ns zu verstehen, wobei der Puls auf ein Trägersignal aufmoduliert ist, das eine Frequenz von mindestens 20MHz aufweist. Der Puls weist eine rechteckige, eine gaußförmige oder eine andere Pulsform auf. Das hochfrequente elektromagnetische Feld wird beispielsweise von der elektrischen rotierenden Maschine 2 erzeugt. Der Sensor 30 ist als ein Temperaturfühler ausgestaltet, welcher einen temperaturabhängigen Widerstand, der beispielsweise aus Platin hergestellt ist, und Zuleitungen umfasst, wobei die Zuleitungen als Antenne zum Auskoppeln des gepulsten hochfrequenten Ereignissignals HF aus dem hochfrequenten elektromagnetischen Feld verwendet werden. Alternativ ist der Sensor 30 als kapazitive Kopplungsvorrichtung, welche mindestens einen Koppelkondensator aufweist, als induktive Kopplungsvorrichtung, welche mindestens eine Koppelspule aufweist, als Richtkoppler oder als ein anderer Teilentladungssensor ausgestaltet.

Insbesondere bei der Verwendung eines Temperaturfühlers als Sensor 30 wird das gepulste hochfrequente Ereignissignal HF nach dem Auskoppeln von einem niederfrequenten Temperatursignal NF mit Hilfe einer Frequenzweiche 32 getrennt, wobei die weitere Verarbeitung des niederfrequenten Temperatursignals in FIG 2 aus Gründen der Übersichtlichkeit nicht dargestellt ist. Mit Hilfe einer Hochfrequenz-Detektorschaltung 34 wird vom gepulsten hochfrequenten Ereignissignal HF ein pulsförmiges niederfrequentes Hüllkurvensignal HK ermittelt. Dabei ist das am Ausgang der Hochfrequenz-Detektorschaltung 34 anliegende Hüllkurvensignal HK zum Logarithmus der Amplitude des gepulsten hochfrequenten Ereignissignals proportional. Die Hochfrequenz-Detektorschaltung 34 weist beispielsweise zumindest eine, insbesondere temperaturkompensierte, Schottky-Diode auf und ist beispielsweise bis zu einer Frequenz von 1GHz verwendbar.

Das Hüllkurvensignal HK wird von einem Schwellenwertschalter 36 weiter verarbeitet. Der Schwellenwertschalter 36 ist als Komparator ausgestaltet, wobei der Komparator bei einer steigenden Flanke des Hüllkurvensignals HK ab einem, insbesondere einstellbaren, Schwellwert einen ersten Spannungswert ausgibt und bei einer fallenden Flanke des Hüllkurvensignals HK unterhalb des Schwellwerts einen zweiten Spannungswert ausgibt, welcher vom ersten Spannungswert verschieden ist. Insbesondere wird vom Komparator eine logische 1 ausgegeben, wenn das Hüllkurvensignal HK oberhalb des Schwellwerts liegt, und eine logische 0 ausgegeben, wenn das Hüllkurvensignal HK unterhalb des Schwellwerts liegt. Beispielsweise gibt der Komparator ein CMOS- oder ein TTL-Signal aus. Alternativ ist der Schwellenwertschalter 36 als Schmitt-Trigger ausgeführt.

Der Ausgang des Schwellenwertschalters 36 ist mit einer Schnittstelle 38 eines programmierbaren Logikbausteins 40, welcher als Mikrocontroller ausgeführt ist, verbunden. Alternativ ist der programmierbare Logikbaustein 40 als FPGA oder andersartig ausgeführt. Überschreitet die Amplitude des Hüllkurvensignals HK den Schwellwert, gibt der Komparator eine logische 1 aus und es wird eine Teilentladung erfasst. Darüber hinaus werden im Mikrocontroller mit Hilfe des vom Schwellenwertschalter 36 erzeugten Ausgangssignals, beispielsweise durch einen Impulszähler, eine Anzahl und eine Zeitdauer der Teilentladungen ermittelt. Über einen Digital-Analog-Umsetzer 42 im Mikrocontroller wird ein Schwellwertsignal SW an den Schwellenwertschalter 36 ausgegeben. Ferner weist der Mikrocontroller einen, insbesondere mehrkanaligen, Analog-Digital-Umsetzer 44 und einen Pulsweiten-Modulator 46 auf. Durch eine Steuereinheit 48, welche dem Mikrocontroller zugewiesen ist, wird der Verfahrensablauf gesteuert. Die ermittelten Daten, insbesondere die Anzahl und die Zeitdauer der Teilentladungen, werden zumindest teilweise an die IT-Infrastruktur 28 gesendet. Die Daten werden mit Hilfe einer auf der IT-Infrastruktur 28 aufsetzenden IoT-Plattform weiter verarbeitet, wobei von der IoT-Plattform ein Service zur Verfügung gestellt wird. Ein derartiger Service ist beispielsweise das Auslösen einer Benachrichtigung bei einer definierten Veränderung der Daten.

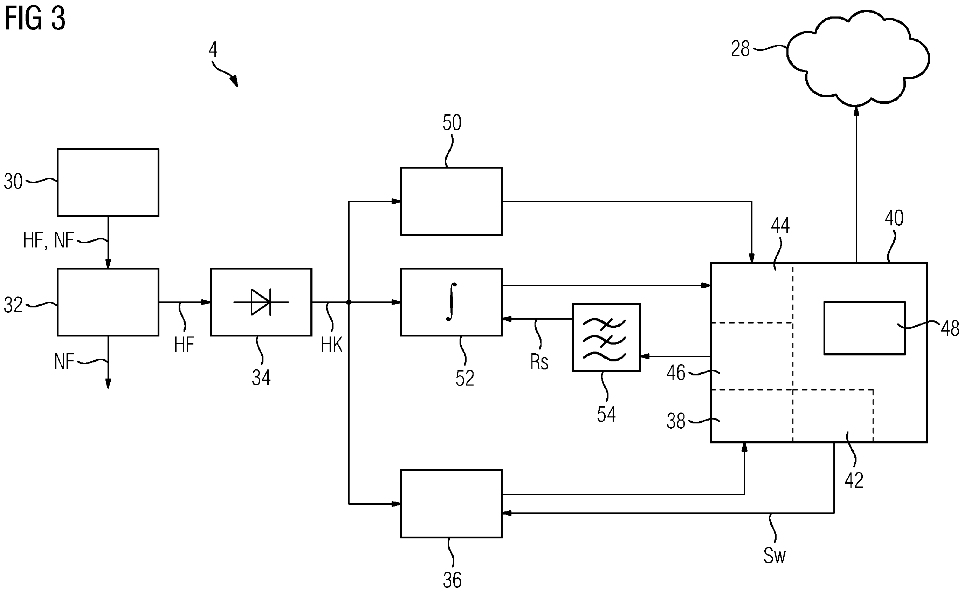

FIG 3 zeigt ein Blockschaltbild einer zweiten Ausführungsform einer Sensorvorrichtung 4. Das Hüllkurvensignal HK wird, neben dem Schwellenwertschalter 36, von einem Spitzenwertdetektor 50 sowie von einem Integrator 52 weiterverarbeitet. Überschreitet die Amplitude des Hüllkurvensignals HK den Schwellwert im Schwellenwertschalter 36, wird zusätzlich ein Messvorgang gestartet, unterschreitet die Amplitude des Hüllkurvensignals HK den Schwellwert daraufhin, wird der Messvorgang wieder gestoppt. Während des Messvorgangs wird vom Spitzenwertdetektor 50 der maximale Amplitudenwert des Hüllkurvensignals HK ermittelt und über den Analog-Digital-Umsetzer 44 an den Mikrocontroller weitergeleitet. Der Analog-Digital-Umsetzer 44 des Mikrocontrollers weist mehrere, insbesondere zwei, Eingangskanäle auf. Alternativ weist der Mikrocontroller zwei separate Analog-Digital-Umsetzer 44 auf oder mindestens ein Analog-Digital-Umsetzer 44 ist als separater Halbleiterbaustein ausgeführt und über Leitungen mit dem Mikrocontroller verbunden. Nach dem Ende der Analog-Digital-Umsetzung wird der Spitzenwertdetektor 50, beispielsweise durch einen niederohmigen Abschluss, zurückgesetzt. Aus dem Ausgangssignal des Spitzenwertdetektors 50 wird im Mikrocontroller jeweils ein maximaler Amplitudenwert der einzelnen Teilentladungen ermittelt und gespeichert.

Darüber hinaus wird vom Integrator 52 der Teil des Hüllkurvensignals HK, der über dem mit Hilfe des Mikrocontrollers einstellbaren Referenzwert liegt, integriert. Weist das Hüllkurvensignal HK einen Gleichspannungsoffset auf, wird der Referenzwert so gewählt, dass der Gleichspannungsoffset keinen Beitrag zum Ausgangssignal des Integrators 52 liefert. Der Referenzwert wird über ein Referenzsignal Rs, welches von einem Pulsweiten-Modulator 46 des Mikrocontrollers über ein Tiefpassfilter 54 dem Integrator 52 zur Verfügung gestellt wird, eingestellt. Das Tiefpassfilter 54 ist beispielsweise als RC-Filter oder LC-Filter ausgeführt. Aus dem Ausgangssignal des Integrators 52 wird eine Leistung des gepulsten hochfrequenten Ereignissignals HF ermittelt. Aus dem Ausgangssignal des Integrators 52 wird im Mikrocontroller jeweils eine, insbesondere mittlere, Leistung der einzelnen Teilentladungen ermittelt und gespeichert.

Insbesondere der Spitzenwertdetektor 50 und/oder der Integrator 52 reagieren auf Störsignale und analoge Störeinflüsse, wie beispielsweise Rauschen und Drift, der analogen Schaltungen unter Umständen durch Ausgabe eines mit der Zeit zunehmend fehlerhaften Ausgangssignals. Deshalb sind der Spitzenwertdetektor 50 und/oder der Integrator 52 vom Mikrocontroller, beispielsweise durch einen niederohmigen Abschluss der betreffenden Signalleitung, zurücksetzbar ausgeführt. Beispielsweise werden die Schaltungen 50, 52 nach der Messung einer Teilentladung wieder zurückgesetzt, um mit hoher Zuverlässigkeit und Genauigkeit eine neue Teilentladung zu messen. Die ermittelten Daten, insbesondere die Anzahl und die Zeitdauer der Teilentladungen, die maximalen Amplitudenwerte und die Leistung der einzelnen Teilentladungen, werden zumindest teilweise an die IT-Infrastruktur 28 gesendet. Die weitere Ausführung der Sensorvorrichtung 4 in FIG 3 entspricht der Ausführung in FIG 2.

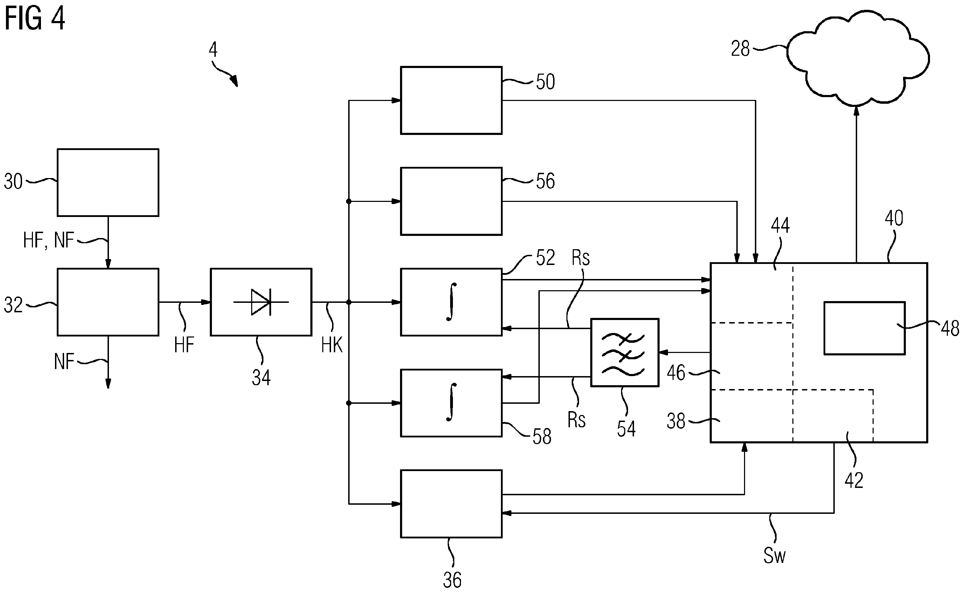

FIG 4 zeigt ein Blockschaltbild einer dritten Ausführungsform einer Sensorvorrichtung 4. Das Hüllkurvensignal HK wird, neben dem Schwellenwertschalter 36, von jeweils zwei Spitzenwertdetektoren 50, 56 sowie von zwei Integratoren 52, 58 weiterverarbeitet. Die Spitzenwertdetektoren 50, 56 und Integratoren 52, 58 werden im Wechsel betrieben. Dabei sind ein erster Spitzenwertdetektor 50 und ein erster Integrator 52, insbesondere durch einen hochohmigen Abschluss, aktiviert, während ein zweiter Spitzenwertdetektor 56 und ein zweiter Integrator 58, insbesondere durch einen niederohmigen Abschluss, deaktiviert sind. Der Schwellenwertschalter 36, welcher als Komparator ausgeführt ist, reagiert auf die steigende Flanke eines Teilentladungsimpulses ab dem einstellbaren Schwellwert Sw und löst den Messvorgang aus. Durch Erhöhung eines Impulszählers im Mikrocontroller wird die Teilentladung zusammen mit einem ersten Zeitpunkt der Teilentladung erfasst und gespeichert. Nach einer Unterschreitung des Schwellwerts Sw der fallenden Flanke des Teilentladungsimpulses wird ein zweiter Zeitpunkt der Teilentladung erfasst und gespeichert, wobei aus dem ersten Zeitpunkt und dem zweiten Zeitpunkt des Teilentladungsimpulses eine Dauer der Teilentladung ermittelt wird. Ferner werden der gerade nicht genutzte zweite Spitzenwertdetektor 56 und der zweite Integrator 58, insbesondere durch einen hochohmigen Abschluss, aktiviert, damit von diesen eine neue Teilentladung verarbeitbar ist. Darüber hinaus beginnt die Analog-Digital-Umsetzung der Ausgangssignale des ersten Spitzenwertdetektors 50 und des ersten Integrators 52. Nach dem Ende der Analog-Digital-Umsetzung werden der erste Spitzenwertdetektor 50 und der erste Integrator 52, insbesondere durch einen niederohmigen Abschluss, zurückgesetzt. Durch den alternierenden Betrieb der Spitzenwertdetektoren 50, 56 und der Integratoren 52, 58 erfolgt eine parallelisierte analoge Signalverarbeitung, welche den Mikrocontroller entlastet. Die weitere Ausführung der Sensorvorrichtung 4 in FIG 4 entspricht der Ausführung in FIG 3.

Zusammenfassend betrifft die Erfindung ein Verfahren zur Messung eines gepulsten hochfrequenten Ereignissignals HF, insbesondere einer Teilentladung, in einer elektrischen rotierenden Maschine 2. Um im Vergleich zum Stand der Technik, eine einfache und kostengünstige Implementierung zu erreichen, wird vorgeschlagen, dass das Ereignissignal HF aus einem hochfrequenten elektromagnetischen Feld mit Hilfe eines Sensors 30 während eines Betriebes der elektrischen rotierenden Maschine 2 ausgekoppelt wird, wobei aus dem ausgekoppelten Ereignissignal HF mit Hilfe einer Hochfrequenz-Detektorschaltung 34 ein pulsförmiges niederfrequentes Hüllkurvensignal HK ermittelt wird, wobei, wenn eine Amplitude des Hüllkurvensignals HK einen Schwellwert Sw überschreitet, ein Ereignissignal HF erfasst wird.

## Patentansprüche

1. Verfahren zur Messung eines gepulsten hochfrequenten Ereignissignals (HF), insbesondere einer Teilentladung, in einer elektrischen rotierenden Maschine (2),
wobei das Ereignissignal (HF) aus einem hochfrequenten elektromagnetischen Feld mit Hilfe eines Sensors (30) während eines Betriebes der elektrischen rotierenden Maschine (2) ausgekoppelt wird,
wobei aus dem ausgekoppelten Ereignissignal (HF) mit Hilfe einer Hochfrequenz-Detektorschaltung (34) ein pulsförmiges niederfrequentes Hüllkurvensignal (HK) ermittelt wird,
wobei, wenn eine Amplitude des Hüllkurvensignals (HK) einen Schwellwert (Sw) überschreitet, ein Ereignissignal (HF) erfasst wird.

2. Verfahren nach Anspruch 1,
wobei die Hochfrequenz-Detektorschaltung (34) derartig konfiguriert wird, dass die Amplitude des Hüllkurvensignals (HK) im Wesentlichen proportional zum Logarithmus der Amplitude des Ereignissignals (HF) ist.

3. Verfahren nach einem der Ansprüche 1 oder 2,
wobei ein Temperaturfühler, welcher eine Antenne umfasst, als Sensor (30) zum Auskoppeln des Ereignissignals (HF) verwendet wird.

4. Verfahren nach Anspruch 3,
wobei das gepulste hochfrequente Ereignissignal (HF) nach dem Auskoppeln durch den Sensor (30) von einem niederfrequenten Sensorsignal (NF), insbesondere mit Hilfe einer Frequenzweiche (32), getrennt wird.

5. Verfahren nach einem der vorherigen Ansprüche,
wobei eine Anzahl von Ereignissignalen (HF) und/oder eine Zeitdauer zumindest eines Ereignissignals (HF) ermittelt werden.

6. Verfahren nach einem der vorherigen Ansprüche,
wobei ein Maximalwert der Amplitude zumindest eines Teils des Hüllkurvensignals (HK) mit Hilfe eines ersten Spitzenwertdetektors (50) ermittelt wird.

7. Verfahren nach Anspruch 6,
wobei der erste Spitzenwertdetektor (50) und ein gleichartiger zweiter Spitzenwertdetektor (56) im Wechsel, insbesondere bei einer fallenden Flanke des Hüllkurvensignals (HK), aktiviert und deaktiviert werden.

8. Verfahren nach einem der vorherigen Ansprüche,
wobei eine Leistung zumindest eines Teils des Hüllkurvensignals (HK) mit Hilfe eines ersten Integrators (52) ermittelt wird.

9. Verfahren nach Anspruch 8,
wobei der erste Integrator (52) und ein gleichartiger zweiter Integrator (58) im Wechsel, insbesondere bei einer fallenden Flanke des Hüllkurvensignals (HK), aktiviert und deaktiviert werden.

10. Verfahren nach einem der Ansprüche 5 bis 9,
wobei eine Anzahl von Ereignissignalen (HF), eine Zeitdauer zumindest eines Ereignissignals (HF), ein Maximalwert der Amplitude zumindest eines Teils des Hüllkurvensignals (HK) und/oder eine Leistung zumindest eines Teils des Hüllkurvensignals (HK) digitalisiert werden.

11. Verfahren nach Anspruch 10,
wobei die digitalisierten Daten zumindest teilweise in einer zentralen IT-Infrastruktur (20) weiter verarbeitet werden.

12. Steuereinheit (48) mit Mitteln zur Durchführung eines Verfahrens nach einem der Ansprüche 1 bis 11.

13. Computerprogramm zur Durchführung eines Verfahrens nach einem der Ansprüche 1 bis 11 bei Ablauf in einer Steuereinheit (48) nach Anspruch 12.

14. Computerprogrammprodukt mit einem Computerprogramm nach Anspruch 13.

15. Sensorvorrichtung (4) zur Durchführung eines Verfahrens nach einem der Ansprüche 1 bis 11,
welche zumindest einen Sensor (30) und eine Steuereinheit (48) nach Anspruch 12 aufweist.

16. Elektrische rotierende Maschine (2) mit mindestens einer Sensorvorrichtung (4) nach Anspruch 15.
